# EUROPEAN PATENT APPLICATION

(11) **EP 2 690 671 A1**
(43) Date of publication of application: **29.01.2014**
(21) Application number: 12760890.9
(22) Date of filing: 23.03.2012
(51) Int. Cl.: H01L 31/042

(54) **SOLAR CELL MODULE, MANUFACTURING METHOD FOR SOLAR CELL MODULE, AND REEL-WOUND BODY WITH TAB WIRE WOUND THEREAROUND**

(30) Priority: 23.03.2011 JP 2011064797
(71) Applicant: Dexerials Corporation, Tokyo 141-0032 (JP)
(72) Inventor: SUGA, Yasuhiro, Shinagawa-ku, Tokyo 141 0032 (JP); KISHIMOTO, Souichiro, Shinagawa-ku, Tokyo 141 0032 (JP)
(74) Representative: Müller - Hoffmann & Partner
(86) International application number: PCT/JP2012/057613
(87) International publication number: WO 2012/128366

(57) **Abstract**

The present invention improves connection reliability when using a conductive adhesive agent to connect a tab wire and an electrode of a solar cell. The invention is provided with: a plurality of solar cells (2); and tab wires (3) that are connected via a conductive adhesive agent (17) including spherical conductive particles (23) to electrodes (11, 13) that are respectively formed on the surfaces of the solar cells (2) and the rear surfaces of adjacent solar cells (2) to connect pairs of solar cells (2). One surface of each tab wire (3) in contact with the conductive adhesive agent (17) has a convexo-concave portion (18) formed thereon, wherein an average height (H) of the convexo-concave portion (18) and an average particle diameter (D) of the conductive particles satisfy D ≧ H.

## Description

### Field of the Invention

This invention relates to a solar cell module in which a plurality of solar cells are connected to one another by tab wires, and more particularly concerns a tab wire that is connected to an electrode of the solar cell with a conductive adhesive agent containing conductive particles being interpolated therebetween, a solar cell module using this tab wire and a method for manufacturing such a solar cell module.

The present application asserts priority rights based on JP Patent Application 2011-64797 filed in Japan on March 23, 2011. The total contents of disclosure of the Patent Application of the senior filing date are to be incorporated by reference into the present Application.

### Background of the Invention

For example, in a crystal silicon-based solar cell module, a plurality of adjacent solar cells are connected to one after another by tab wires forming interconnectors. Each tab wire has its one end connected to a surface electrode of one solar cell, with the other end being connected to the rear surface electrode of an adjacent solar cell, so that the respective solar cells are series-connected to one after another. At this time, the tab wire has its one surface on the one end side connected to the surface electrode of the one solar cell, with the other surface on the other end side being connected to the rear surface of the adjacent solar cell.

More specifically, on the solar cell, a busbar electrode is formed on the light-receiving surface thereof by a screen printing process using a silver paste or the like, and an Ag electrode is formed on a rear surface connection portion of the solar cell. Additionally, on an area other than the connection portion of the rear surface of the solar cell, an Al electrode and an Ag electrode are formed.

Moreover, the tab wire is formed by placing a solder coat layer on each of the two surfaces of a ribbon-shaped copper foil. More specifically, the tab wire is formed through processes in which a copper foil that has been rolled to have a thickness of about 0.05 to 0.2 mm is slit, or a copper wire is rolled into a flat-plate shape to prepare a flat square copper wire having a width of 1 to 3 mm, and a solder plating process or a dip soldering process is carried out thereon.

The connection between the solar cell and the tab wire is carried out through processes in which the tab wire is disposed on the respective electrodes of the solar cell, and by thermally compressing this by a heating bonder, solder formed on the surface of the tab wire is fused and cooled thereon (Patent Document 1).

However, in the case of soldering, since the connection process is carried out at a high temperature such as about 260°C, there might be a problem with connection reliability between the surface electrode as well as the rear surface electrode of the solar cell and the tab wire due to a warping of the solar cell, an inner stress caused in the connection portion between the tab wire and the surface electrode as well as the rear surface electrode, and flux residues, etc.

For this reason, as a connection method between the tab wire and the surface electrode as well as the rear surface electrode of a solar cell, a method has been proposed in which a conductive adhesive film, which can be connected by a thermal press-bonding process at a comparatively low temperature, is used (Patent Document 2). As such a conductive adhesive film, spherical or scale-shaped conductive particles having an average particle diameter in the order of several µms are dispersed in a thermosetting-type binder resin composition, and this is formed into a film, and used.

After having been interposed between the surface electrode as well as the rear surface electrode and the tab wire, the conductive adhesive film is heated and compressed by a heating bonder from above the tab wire so that the binder resin exerts flowability to flow out among the respective electrodes and the tab wire, with the electrodes and the tab wire being made conductive by the conductive particles, and in this state, the binder resin is hardened. With this arrangement, a string is formed in which the plural solar cells are series-connected with one another by the tab wires.

The plural solar cells each of which has a tab wire connected to a surface electrode and a rear surface electrode by using a conductive adhesive film are sealed between a surface protective member made of glass, a translucent plastic material or the like and having translucency, and a rear surface protective member made of a film such as PET (Poly Ethylene Terephthalate) or the like by using a sealing member made of an ethylene vinyl acetate resin (EVA) or the like and having translucency.

### Prior-Art Documents

### Patent Document

PTL 1: Japanese Patent Application Laid-Open No. 2004-356349
PTL 2: Japanese Patent Application Laid-Open No. 2008-135654

### Summary of the Invention

However, in a structure for joining a surface electrode and a rear surface electrode of a solar cell to a tab wire by using a conductive adhesive film, there have been demands for further improving connection reliability, that is, for connecting the tab wire with the respective electrodes of the solar cell by the conductive adhesive film, with a lower electrical resistance. In particular, in the solar module, since after its installation, temperature and moisture environments change depending on day and night, weathers, or four seasons, it is desired to maintain a stable connection state even under these environmental changes.

Therefore, the object of the present invention is to provide a solar cell module that has improved connection reliability upon connecting a tab wire and the respective electrodes of a solar cell by using a conductive adhesive film, a method for manufacturing such a solar cell module and a reel-wound body on which the tab wire is mound around.

In order to solve the above-mentioned problems, a solar cell module in accordance with the present invention is provided with: a plurality of solar cells and a tab wire that is connected to electrodes that are respectively formed on a surface of each of the solar cells and a rear surface of an adjacent solar cell, with a conductive adhesive agent containing spherical conductive particles being interpolated therebetween, so that the plural solar cells are mutually connected to one after another, and in this structure, the tab wire is provided with a convexo-concave portion formed on one surface thereof that is in contact with the conductive adhesive agent, with an average height (H) of the convexo-concave portion and an average particle diameter (D) of the conductive particles being allowed to satisfy D ≧ H.

Moreover, a method for manufacturing a solar cell module in accordance with the present invention is provided with the steps of: disposing one end of a tab wire on a surface electrode of each of solar cells, with a conductive adhesive agent containing spherical conductive particles being interpolated therebetween, and the other end of the tab wire on a rear surface electrode of a solar cell adjacent to the solar cell, with the conductive adhesive agent containing conductive particles being interpolated therebetween; and thermally compressing the tab wire on the surface electrode and the rear surface electrode so that the tab wire is connected to the surface electrode and the rear surface electrode with the conductive adhesive agent, and in this method, the tab wire is provided with a convexo-concave portion formed on one surface thereof that is in contact with the conductive adhesive agent, with an average height (H) of the convexo-concave portion and an average particle diameter (D) of the conductive particles being allowed to satisfy D ≧ H.

Furthermore, a reel-wound body in accordance with the present invention is provided with: a tab wire that is connected to electrodes formed on a surface of each of solar cells and a rear surface of an adjacent solar cell respectively, with a conductive adhesive agent containing spherical conductive particles being interpolated therebetween, so that the plural solar cells are mutually connected to one after another, with the tab wire being wound around a reel, and in this structure, the tab wire is provided with a convexo-concave portion formed on one surface thereof that is in contact with the conductive adhesive agent, with an average height (H) of the convexo-concave portion and an average particle diameter (D) of the conductive particles being allowed to satisfy D ≧ H.

### Effects of the Invention

In accordance with the present invention, since the tab wire is designed such that the average height (H) of the convexo-concave portion and the average particle diameter (D) of the conductive particles dispersed in a conductive adhesive agent satisfy D ≧ H, the conductive particles are held in concave portions of the convexo-concave portion, and made in contact with the respective electrodes of the solar cell. Therefore, the tab wire is allowed to have an increased contact area to the respective electrodes of the solar cell by means of the convex portions of the convexo-concave portion and the conductive particles, thereby making it possible to reduce resistance to conduction.

### Brief Description of Drawings

Figure 1 is an exploded perspective view showing a structure of a solar cell module in accordance with a first embodiment to which the present invention is applied.
Figure 2 is a cross-sectional view showing strings of a solar cell.
Figure 3 is a plan view showing a rear surface electrode and a connection portion of the solar cell.
Figure 4 is a cross-sectional view that shows a tab wire on which a conductive adhesive agent has been preliminarily applied.
Figure 5 is a cross-sectional view showing a connection state of an electrode of the solar cell and the tab wire.
Figure 6 is a perspective view showing a reel-wound body with the tab wire.
Figure 7 is a cross-sectional view showing a conductive adhesive film.
Figure 8 is a view that shows the conductive adhesive film wound around onto a reel shape.
Figure 9 is a cross-sectional view showing an example and a comparative example.
Figure 10 is a plan view showing the example and the comparative example.

### Detailed Description of the Invention

Referring to Figures, the following description will discuss a solar cell module to which the present invention is applied, a method for manufacturing such a solar cell and a reel-wound body around which a tab wire is wound in detail.

### [Solar Cell Module]

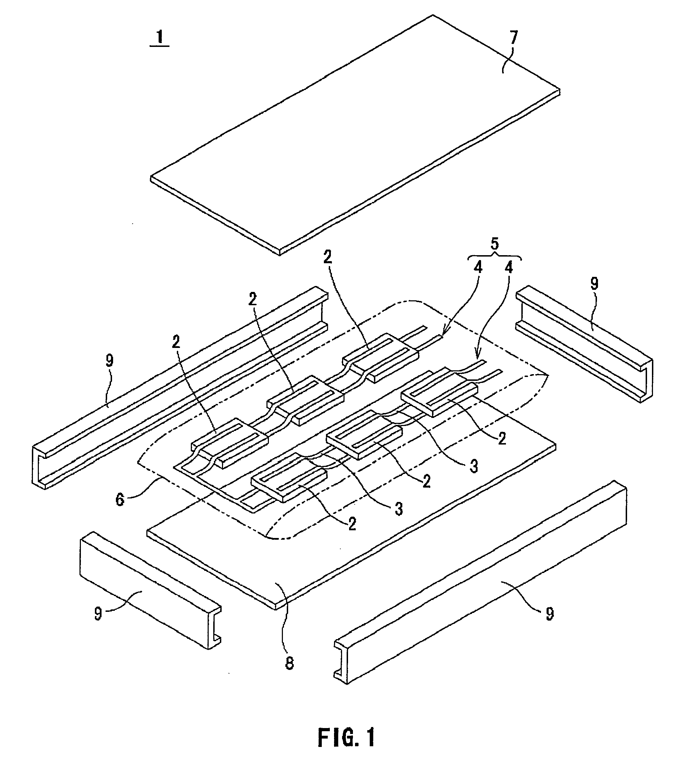

As shown in Figs. 1 to 3, a solar cell module 1 to which the present invention is applied is provided with: a string 4 in which a plurality of solar cells 2 are connected in series with one another by tab wires 3 serving as interconnectors, and a matrix 5 in which a plurality of the strings 4 are arranged. Then, this solar cell module 1 is formed by processes in which the matrix 5 is sandwiched by sheets 6 made of a sealing adhesive agent, and laminated as one lot together with a surface cover 7 formed on the light-receiving side and a back sheet 8 formed on the rear surface side, and lastly a metal frame 9 made of aluminum or the like is attached onto the peripheral portion.

As the sealing adhesive agent, a translucent sealing material, for example, such as an ethylene vinyl acetate resin (EVA) or the like, is used. Moreover, as the surface cover 7, a translucent sealing material, for example, such as glass, a translucent plastic material, or the like, is used. As the back sheet 8, a laminate or the like in which glass or an aluminum foil is sandwiched by resin films is used.

Each of the solar cells 2 of the solar cell module has photoelectric conversion elements 10. As the photoelectric conversion element 10, various photoelectric conversion elements 10, such as a crystal silicon-based solar cell using a single crystal-type silicon photoelectric conversion element or a polycrystal-type photoelectric conversion element, and a thin-film silicon-based solar cell using a photoelectric conversion element in which a cell made of amorphous silicon and a cell made of microcrystal silicon and amorphous silicon germanium are stacked on each other, may be used.

Moreover, the photoelectric conversion element 10 is provided with finger electrodes 12 that collect electricity generated the inside thereof and busbar electrodes 11 that collect electricity of the finger electrodes 12, which are formed on the light-receiving surface side. The busbar electrodes 11 and the finger electrodes 12 are formed by processes in which after, for example, an Ag paste has been applied onto the surface forming the light-receiving surface of the solar cell 2 by a screen printing process or the like, a baking process is carried out thereon. The finger electrodes 12 are formed over the entire surface of the light-receiving surface virtually in parallel with each other as a plurality of lines, each having, for example, a width of about 50 to 200µm, that have predetermined intervals, for example, every other 2 mm. The busbar electrodes 11 are formed virtually orthogonal to the finger electrodes 12, and a plurality thereof are formed in accordance with the area of the solar cell 2.

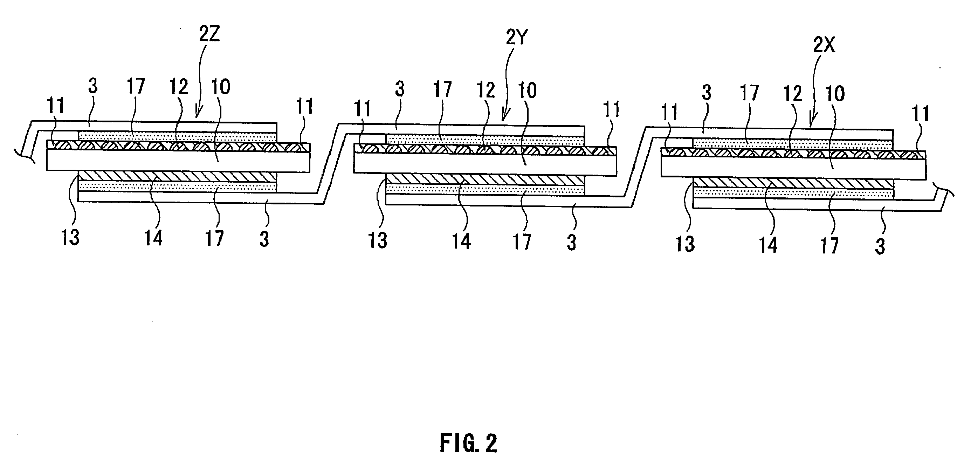

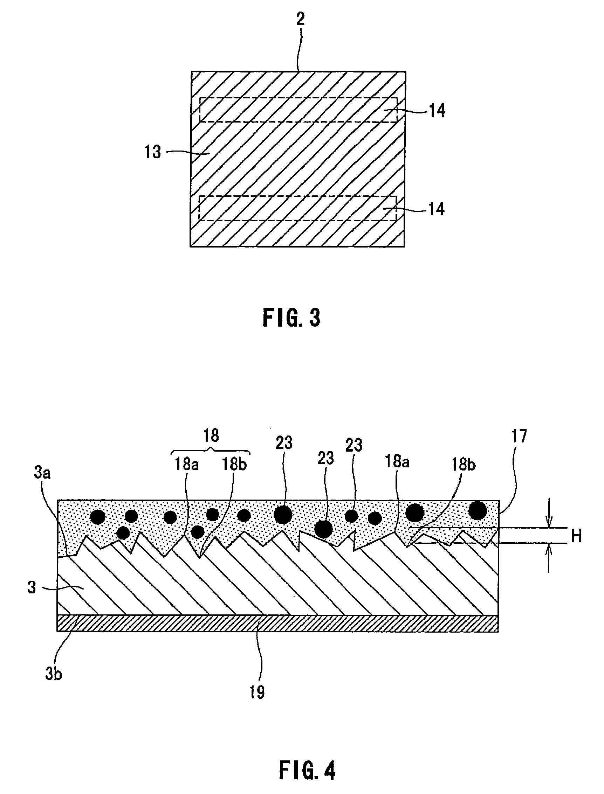

A rear surface electrode 13 made of aluminum or silver is formed on the rear surface side opposite to the light-receiving surface of the photoelectric conversion element 10. As shown in Figs. 2 and 3, the rear surface electrode 13 is formed as an electrode made of, for example, aluminum or silver, on the rear surface of the solar cell 2 by a screen printing process, a sputtering process, or the like. The rear surface electrode 13 is provided with a tab wire connection portion 14 to which the tab wires 3 are connected via a conductive adhesive film 17 to be described later.

In the solar cell 2, the respective busbar electrodes 11 formed on the surface thereof and the rear surface electrode 13 of an adjacent solar cell 2 are electrically connected with each other by the tab wires 3 so that a string 4 in which these are series-connected with one after another is formed. The tab wires 3 are connected to the busbar electrodes 11 and the rear surface electrode 3 with the conductive adhesive film 17 to be described later.

### [Tab Wire]

As shown in Fig. 2, the tab wires 3 are conductive base members having an elongated shape that electrically connect adjacent solar cells 2X, 2Y and 2Z with one another. The tab wires 3 are formed, for example, by processes in which a copper foil or an aluminum foil which has been rolled into a thickness of, for example, 50 to 300µm, is slit or a thin metal wire made of copper, aluminum or the like is rolled into a flat plate shape so that a square flat copper wire having a width of 1 to 3 mm that is virtually the same width as the width of the conductive adhesive film 17 is obtained. Then, this square flat copper wire is subjected to a gold-plating, silver-plating, tin-plating or solder-plating process, if necessary, so that the tab wire 3 is formed.

### [Convexo-Concave Portion]

As shown in Fig. 4, the tab wire 3 has a convexo-concave portion 18 formed on one surface 3a that is made in contact with the conductive adhesive film 17. The convexo-concave portion 18 is composed of convex portions and concave portions that are irregularly formed over the entire surface of the one surface 3a of the tab wire 3, and is formed by a press-molding process carried out on a ribbon-shaped copper foil subjected to a plating process, or an etching process or the like carried out on the one surface 3a.

Moreover, with respect to an average height (H) of the convexo-concave portion 18 and an average particle diameter (D) of the conductive particles 23 in the conductive adhesive film 17 to be described later, the tab wire 3 is allowed to satisfy D ≧ H. The average height (H) of the convexo-concave portion 18 refers to an average value of heights from the apex of the concave portion 18b to the apex of the convex portion 18a, and the average value is obtained from heights measured at a plurality of positions, that is, for example, 10 positions. The average height (H) of the convexo-concave portion 18 is applicable when set in a range from 1 to 50µm, and desirably used in a range from 10 to 20µm.

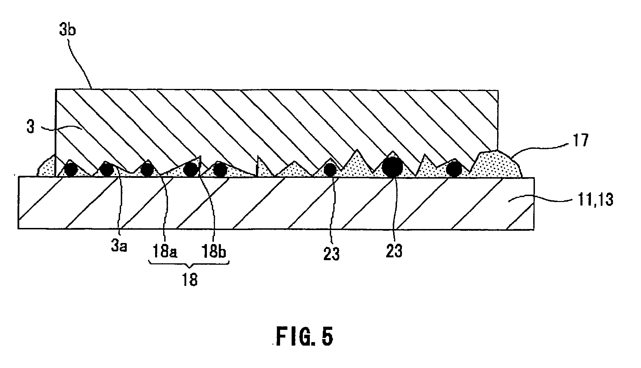

As shown in Fig. 5, in the solar module 1, by satisfying D ≧ H in the average height (H) of the convexo-concave portion 18 of the tab wire 3 and the average particle diameter (D) of the conductive particles 23 in the conductive adhesive film 17, the contact area of the convex portions 18a of the convexo-concave portion 18 and the conductive particles 23 with the busbar electrodes 11 and the rear surface electrode 13 increases, thereby making it possible to reduce the contact resistance.

### [Peeling Process]

Moreover, with respect to the tab wire 3, a peeling process layer 19 may be formed on the other surface 3b on the side opposite to the one surface 3a on which the convexo-concave portion 18 is formed. The peeling process layer 19 may be formed by using a conventionally-known method, that is, by surface-treating the other surface 3b of the tab wire 3 by using a peeling process agent, such as, for example, a silicone-based, long-chain-alkyl-based, fluorine-based, or molybdenum sulfide agent, or the like.

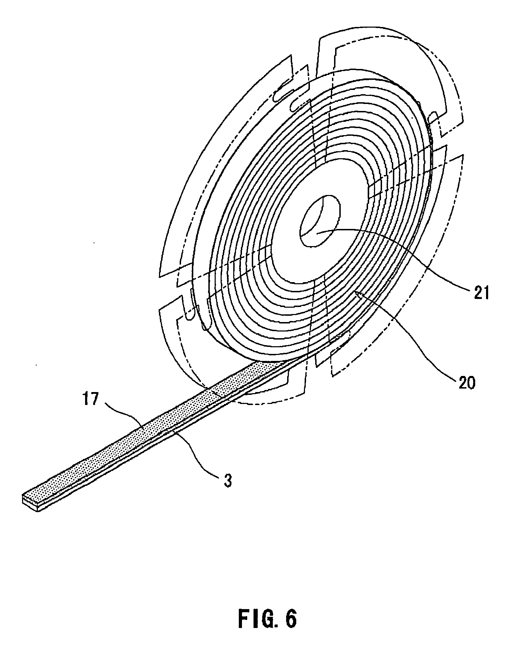

By forming the peeling process layer 19 on the other surface 3b, even when wound around into a reel-wound body 20 as shown in Fig. 6, the tab wire 3 is free from adhesion of the overlapped portions. Therefore, upon placing the tab wire 3 on the busbar electrodes 11 and the rear surface electrode 13, it is smoothly fed out from a reel 21.

### [Adhesive Film]

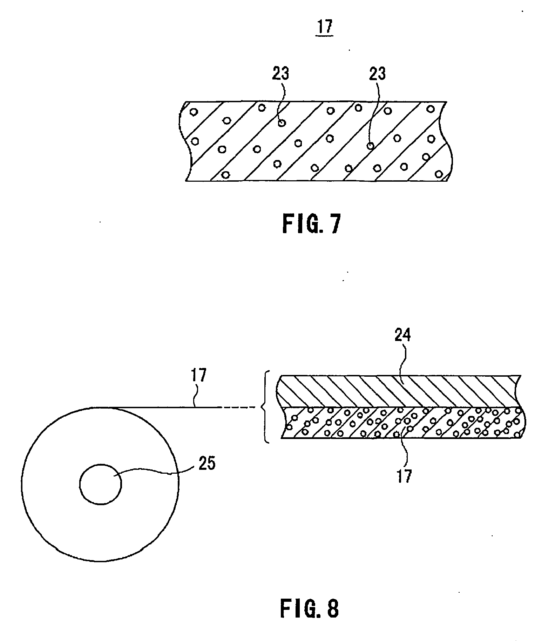

As shown in Fig. 7, the conductive adhesive film 17 is formed as a thermosetting binder resin layer containing spherical conductive particles 23 at a high density. Moreover, from the viewpoint of the push-in characteristic, the conductive adhesive film 17 preferably allows its binder resin to have the lowest melt viscosity in a range from 100 to 100000 Pa·s. When the lowest melt viscosity of the conductive adhesive film 17 is too low, the resin tends to flow from a low press-bonding process to a main curing process to cause any connection failure or any protrusion onto the cell light-receiving surface, resulting in a reduction in light receiving rate. Moreover, when the lowest melt viscosity is too high, a problem tends to occur upon pasting the film, sometimes, resulting in adverse effects in connection reliability. Additionally, the lowest melt viscosity can be measured by loading a predetermined amount of a sample to a rotary viscometer and measuring the viscosity while raising the temperature at a predetermined rate.

Although not particularly limited, as the spherical conductive particles 23 used for the conductive adhesive film 17, examples thereof include: metal particles such as nickel, gold, silver and copper, resin particles that are subjected to gold plating or the like, and those resin particles that are subjected to gold plating, with their outermost layer being coated with an insulating material. Additionally, the spherical shape in the present invention is not limited to a so-called spherical shape, and may have any modes from which the particle size can be assumed and which metal particles and resin particles are generally allowed to take, such as a polygonal body composed of plane surfaces and curved surfaces, in addition to spherical shapes having a virtually round shape or an elliptical shape in the cross-section thereof. Additionally, the average particle diameter of the conductive particles 23 is applicable when set in a range from 1 to 50µm, and preferably used when set in a range from 10 to 30µm.

Moreover, the conductive adhesive film 17 preferably has a viscosity in a range from 10 to 10000 kPa·s, and more preferably, from 10 to 5000 kPa·s, near normal temperature. By setting the viscosity of the conductive adhesive film 17 in the range from 10 to 10000 kPa·s, it becomes possible to prevent blocking due to so-called protrusion at the time when the conductive adhesive film 17 is formed on one surface 3a of the tab wire 3 and wound around the reel 21, and also to maintain a predetermined tacking strength.

Although not particularly limited as long as the above-mentioned characteristics are not impaired, the composition of a binder resin layer of the conductive adhesive film 17 preferably includes a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristic, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., a phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as hot setting-type, UV-setting-type or the like curing agent, may be used. The potential curing agent is not allowed to react normally, but is activated with a certain trigger, and starts a reaction. As the trigger, heat, light, pressure application or the like is used, and by making selection among these depending on the application, any of these may be used. Among these, in the present application, a potential curing agent of the hot-setting type is preferably used, and this is actually hardened when heated and compressed onto the busbar electrode 11 and the rear surface electrode 13. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present specification, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

Fig. 8 is a view that schematically shows one example of a product mode of the conductive adhesive film 17. The conductive adhesive film 17 has a structure in which a binder resin layer is stacked on a peeling base member 24, and is molded into a tape shape. This tape-shaped conductive adhesive film is wound around and stacked on a reel 25, with the peeling base member 24 being located on the peripheral side. As the peeling base member 24, not particularly limited, PET (Poly Ethylene Terephthalate), OPP (Oriented Polypropylene), PMP (Poly-4-methylpentene-1), PTFE (Polytetrafluoroethylene) and the like may be used. Moreover, the conductive adhesive film 17 may have a structure in which a transparent cover film is formed on a binder resin layer.

At this time, as a cover film to be pasted onto the binder resin layer, the aforementioned tab wire 3 may be used. The conductive adhesive film 17 is provided with a binder resin layer stacked onto the one surface 3a on which the convexo-concave portion 18 of the tab wire 3 is formed. In this manner, by preliminarily stacking the tab wire 3 and the conductive adhesive film 17 as one integral laminate, the peeling base member 24 can be separated at the time of an actual application, and by pasting the binder resin layer of the conductive adhesive film 17 onto the tab wire connection portion 14 of the busbar electrodes 11 and the rear surface 13, the tab wire 3 can be connected to the respective electrodes 11 and 13.

In the above description, explanations have been given by exemplifying a conductive adhesive film having a film shape; however, a paste-state conductive adhesive agent may be used without causing any problems. In the present specification, a film-state conductive adhesive film 17 or a paste-state adhesive paste containing conductive particles is defined as "conductive adhesive agent". In the case when the conductive adhesive paste is used also, with respect to the tab wire 3, this conductive adhesive paste is preliminarily applied onto the one surface 3a on which the concavo-convex portion 18 is formed, and the conductive adhesive agent may be pasted onto the respective electrodes 11 and 13 of the solar cell 2.

Additionally, not limited to a reel shape, the conductive adhesive film 17 may have a strip shape in accordance with the shapes of the busbar electrodes 11 and the tab wire connection portion 14 of the rear surface electrode 13.

As shown in Fig. 8, in the case when the conductive adhesive film 17 is provided as a reel product on which it has been wound around, by setting the viscosity of the conductive adhesive film 17 in a range from 10 to 10000 kPa·s, it is possible to prevent the conductive adhesive film 17 from being deformed, and consequently to maintain predetermined dimensions thereof. Moreover, even in the case when the conductive adhesive film 17 has a strip shape and two or more sheets thereof are stacked, in the same manner, it is possible to prevent the deformation, and consequently to maintain predetermined dimensions thereof.

The above-mentioned conductive adhesive film 17 is prepared by dissolving conductive particles 23, a film-forming resin, a liquid-state epoxy resin, a potential curing agent and a silane coupling agent in a solvent. As the solvent, toluene, ethyl acetate, or the like, or a mixed solvent of these, may be used. The resin forming solution obtained by the dissolving process is applied onto a peeling sheet, and by evaporating the solvent, a conductive adhesive film 17 is obtained.

Then, the conductive adhesive film 17 is cut into predetermined lengths as two portions to be used for the surface electrode as well as two portions to be used for the rear surface electrode, and these are temporarily pasted onto predetermined positions on the surface and rear surface of a solar cell 2. At this time, each conductive adhesive film 17 is temporarily pasted onto the plural busbar electrodes 11 formed on the surface of the solar cell 2 virtually in parallel with one another, as well as on the tab wire connection portion 14 of the rear surface electrode 13.

In the same manner, one surface 3a of a tab wire 3 that is cut into a predetermined length is disposed on each conductive adhesive film 17 in an overlapped manner. Thereafter, the conductive adhesive film 17 is heated and compressed at predetermined temperature and pressure from above the tab wire 3 by a heating bonder so that the binder resin is allowed to flow among the respective electrodes, 11, 13 and the tab wires 3, with the conductive particles 23 being sandwiched between the tab wire 3 and the respective electrodes 11 or electrode 13, and in this state, the binder resin is hardened. With this arrangement, the conductive adhesive film 17 allows the tab wire 3 to be adhered to each of the electrodes, and the convex portions 18a of the convexo-concave portion 18 are also made in contact with the busbar electrodes 11 and the rear surface electrode 13 to be connected with one another for conduction.

### [Effects of the Invention]

At this time, the tab wire 3 has such a structure that an average height (H) of the convexo-concave portion 18 and an average particle diameter (D) of the conductive particles 23 dispersed in the binder resin layer of the conductive adhesive film 17 are allowed to satisfy D ≧ H; thus, the conductive particles 23 are held by the concave portions 18b of the convexo-concave portion 18, and made in contact with the busbar electrodes 11 and the rear surface electrode 13. Therefore, the tab wire 3 has an increased contact area to the respective electrodes 11 and 13 of the solar cell 2 by means of the convex portions 18a of the convexo-concave portion 18 and the conductive particles 23, thereby making it possible to reduce resistance to conduction.

Moreover, the tab wire 3 has its one surface 3a which is preliminarily provided with the convexo-concave portion 18 further provided with the conductive adhesive film 17 or the conductive adhesive paste, prior to being pasted onto the respective electrodes 11 and 13 of the solar cell 2, so that since no process for temporarily pasting the conductive adhesive film 17 onto the respective electrodes 11 and 13 is required, it is possible to reduce the number of production processes.

That is, in an engineering method for temporarily pasting the conductive adhesive film onto the electrodes 11 and 13, first, the conductive adhesive film 17 is cut into predetermined lengths in accordance with the lengths of the respective electrodes 11 and 13, and the resultant films are disposed on the respective electrodes 11 and 13, and temporarily hardened by a heating bonder to such an extent as to allow the binder resin layer to exert flowability although not to be actually hardened, and then temporarily pasted thereon. Next, the tab wire 3 is disposed on the conductive adhesive film 17, and heated and compressed by the heating bonder at predetermined temperature and pressure for a predetermined period of time that allow the binder resin to be actually hardened.

On the other hand, in an engineering method for preliminarily stacking the conductive adhesive film onto one of surfaces 3a of the tab wire 3, it is only necessary to prepare process in which the tab wire 3 is disposed on the respective electrodes 11 and 13 via a conductive adhesive agent, and simply heated and compressed by a heating bonder, thereby making it possible to reduce the number of processes in the connection processes for the tab wire 3.

Moreover, by forming a peeling process layer 19 on the other surface 3b of the tab wire 3, a reel-wound body 20 of the tab wire 3 wound around a reel 21 can be smoothly fed from the reel 21 at the time of disposing the tab wire 3 on the busbar electrodes 11 and the rear surface electrode 13, without the overlapped portions being adhered to each other.

### [Batch Laminate]

In addition to the engineering process in which, as described above, after the conductive adhesive agent and tab wire 3 have been disposed on the respective electrodes 11 and 13 of the solar cell 2, heating and compressing processes are applied onto the tab wire 3 by the heating bonder, the solar cell module 1 may be formed by processes in which onto the surface and rear surface of the solar cell 2, the conductive adhesive agent, the tab wire 3 and a translucent sealing member, such as EVA or the like, for sealing the tab wire 3 and the solar cell 2 are successively stacked, and then subjected to a batch laminating process so that the tab wire 3 may be heated and compressed onto the respective electrodes 11 and 13. Examples

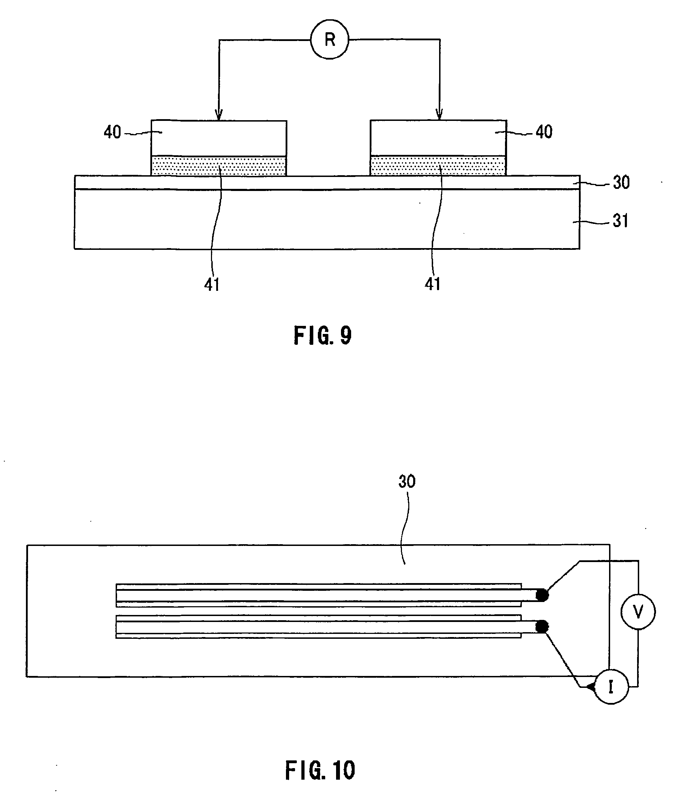

The following description will discuss examples of the present invention. In the examples, as indicated by Table 1, four kinds of conductive adhesive films, which contain Ni having different average particle diameters (D), or do not contain conductive particles, are used as respective conductive adhesive agents. Moreover, as the tab wire, various tab wires having different average heights of the convex portions 18a of the convexo-concave portion 18 or having no convexo-concave portion are used. As shown in Figs. 9 and 10, samples 40 of these respective tab wires were heated and compressed onto Ag electrodes 30 on a glass substrate 31 (thickness: 2.8 mm, outside shape: 64 mm × 28 mm, resistance value: 7 m Ω/ (mΩ/sq)) having a surface on which the Ag electrodes 30 were formed on the entire portion thereof two by two so as to be connected to each other, via each of samples 41 of respective conductive adhesive films.

In each of the examples, the heating and compressing conditions were 180°C, 15 sec, and 2 MPa. Moreover, between the tab wire and the heating bonder, a silicon rubber having a thickness of 200µm was interposed as a buffer member so that the pressure was evenly applied.

After forming the sample, between the two tab wires 40, the initial resistance value and a resistance value after a thermal impact test (85°C, 85%RH, 500 hr) were measured. The resistance value was measured by a 4-terminal method in which a current terminal and a voltage terminal were respectively connected onto the two tab wires 40.

Additionally, the tab wire 40 used in each of examples and comparative examples was wound around a reel to form a reel-wound body (see Fig. 6), and the drawing characteristic was evaluated as to whether or not the drawing of each of the wound-around bodies was carried out smoothly.

**[Table 1]**

| Kinds | Raw material | Composition (wt%) | | | |
|---|---|---|---|---|---|
| | | Adhesive Agent 1 | Adhesive Agent 2 | Adhesive Agent 3 | Adhesive Agent 4 |
| Epoxy resin | Epicoat 828 (made by Japan Epoxy Resins Co., Ltd.) | 30 | 30 | 30 | 30 |
| | Phenote YP50 (made by Tohto Kasei Co., Ltd.) | 20 | 20 | 20 | 20 |
| Potential curing agent | HX3941HP (made by Asahi Kasei E-Materials Corporation) | 50 | 50 | 50 | 50 |
| Conductive particles | Nickel particles (spherical) average particle size 10 µm (Vale Inco Japan Limited.) | 15 | - | - | - |
| | Nickel particles (spherical) average particle size 20 µm (Vale Inco Japan Limited.) | - | 15 | - | - |
| | Nickel particles (spherical) average particle size 30 µm (Vale Inco Japan Limited.) | - | | 15 | - |

In example 1, as a tab wire, a tab wire 3 having an average height (H) of a convexo-concave portion 18 of 10µm formed on one surface 3a, with a peeling process layer 19 being formed on the other surface 3b, was used. Moreover, as a conductive adhesive agent, an adhesive agent 1 shown in Table 1, i.e., a conductive adhesive film 17 having Ni particles forming conductive particles 23 with an average particle diameter (D) of 10µm, was used. In example 1, the average height (H) of the convexo-concave portion 18 and the average particle diameter (D) of the conductive particles 23 satisfied D = H.

In example 2, as a tab wire, the tab wire 3 that was the same as example 1 was used. Moreover, as a conductive adhesive agent, an adhesive agent 2 shown in Table 1, i.e., a conductive adhesive film 17 having Ni particles forming conductive particles 23 with an average particle diameter (D) of 20µm, was used. In example 2, the average height (H) of the convexo-concave portion 18 and the average particle diameter (D) of the conductive particles 23 had a relationship of D > H.

In example 3, as a tab wire, the tab wire 3 that was the same as example 1 was used. Moreover, as a conductive adhesive agent, an adhesive agent 3 shown in Table 1, i.e., a conductive adhesive film 17 having Ni particles forming conductive particles 23 with an average particle diameter (D) of 30µm, was used. In example 3, the average height (H) of the convexo-concave portion and the average particle diameter (D) of the conductive particles 23 had a relationship of D > H.

In example 4, as a tab wire, a tab wire having an average height (H) of a convexo-concave portion 18 of 20µm formed on one surface 3a, with a peeling process layer 19 being formed on the other surface 3b, was used. Moreover, as a conductive adhesive agent, the adhesive agent 2 shown in Table 1, i.e., a conductive adhesive film 17 having Ni particles forming conductive particles 23 with an average particle diameter (D) of 20µm, was used. In example 4, the average height (H) of the convexo-concave portion 18 and the average particle diameter (D) of the conductive particles 23 satisfied D = H.

In example 5, as a tab wire, the tab wire that was the same as example 4 was used. Moreover, as a conductive adhesive agent, an adhesive agent 3 shown in Table 1, i.e., a conductive adhesive film 17 having Ni particles forming conductive particles 23 with an average particle diameter (D) of 30µm, was used. In example 5, the average height (H) of the convexo-concave portion 18 and the average particle diameter (D) of the conductive particles 23 had a relationship of D > H.

In example 6, as a tab wire, a tab wire having an average height (H) of a convexo-concave portion 18 of 10µm formed on one surface 3a, without a peeling process layer 19 formed on the other surface 3b, was used. Moreover, as a conductive adhesive agent, the adhesive agent 1 shown in Table 1, i.e., a conductive adhesive film 17 having Ni particles forming conductive particles 23 with an average particle diameter (D) of 10µm, was used. In example 6, the average height (H) of the convexo-concave portion 18 and the average particle diameter (D) of the conductive particles 23 satisfied D = H.

In comparative example 1, as a tab wire, a tab wire having no convexo-concave portion formed on one surface (H = 0), with a peeling process layer formed on the other surface, was used. Moreover, as a conductive adhesive agent, the adhesive agent 1 shown in Table 1, i.e., a conductive adhesive film 17 having Ni particles forming conductive particles 23 with an average particle diameter (D) of 10µm, was used. In comparative example 1, the average height (H) of the convexo-concave portion and the average particle diameter (D) of the conductive particles 23 had a relationship ofD > H.

In comparative example 2, as a tab wire, the tab wire 3 that was the same as example 1 was used. Moreover, as a conductive adhesive agent, the adhesive agent 4 shown in Table 1, i.e., an insulating adhesive film having no conductive particles 23, was used.

In comparative example 3, as a tab wire, the tab wire 3 that was the same as example 4 was used. Moreover, as a conductive adhesive agent, the adhesive agent 1 shown in Table 1, i.e., a conductive adhesive film 17 having Ni particles forming conductive particles 23 with an average particle diameter (D) of 10µm, was used. In comparative example 1, the average height (H) of the convexo-concave portion 18 and the average particle diameter (D) of the conductive particles 23 had a relationship of D < H.

With respect to each of samples, the initial resistance value and the resistance value after a thermal impact test (85°C, 85%RH, 500 hr) and a draw-out characteristic of a reel-wound body of a tab wire used in each of the samples were evaluated and the results thereof are shown in Table 2.

**[Table 2]**

| | Example 1 | Example 2 | Example 3 | Example 4 | Example 5 | Example 6 | Comparative Example 1 | Comparative Example 2 | Comparative Example 3 |
|---|---|---|---|---|---|---|---|---|---|
| Adhesive agent | Adhesive agent 1 | Adhesive agent 2 | Adhesive agent 3 | Adhesive agent 2 | Adhesive agent 3 | Adhesive agent 1 | Adhesive agent 1 | Adhesive agent 4 | Adhesive agent 1 |
| Average particle diameter D ofN particles (µm) | 10 | 20 | 30 | 20 | 30 | 10 | 10 | - | 10 |
| Average height H of convexo-concave portion (µm) | 10 | 10 | 10 | 20 | 20 | 10 | 0 | 10 | 20 |
| D-H | 0 | 10 | 20 | 0 | 10 | 0 | 10 | - | -10 |
| Relationship of H and D | D=H | D>H | D>H | D=H | D>H | D=H | D>H | - | D<H |
| Presence/absence of peeling process layer | Yes | Yes | Yes | Yes | Yes | No | Yes | Yes | Yes |
| Connection resistance value (mΩ) | 5 | 7 | 25 | 5 | 10 | 5 | 30 | Unmeasurable | 10 |
| Reliability after 85°C-85%RH, 500 hr (mΩ) | 7 | 10 | 50 | 7 | 12 | 7 | 50 | Unmeasurable | 100 |
| Draw-out characteristic | ○ | ○ | ○ | ○ | ○ | Δ | ○ | ○ | ○ |
| Determination | ⊚ | ○ | Δ | ⊚ | Δ | Δ | × | × | × |

As shown in Table 2, in each of examples, the connection resistance between the tab wire and the Ag electrode 30 are low in the initial value as well as after the thermal impact test, and the draw-out characteristic of the tab wire from the reel-wound body is good so that it is found that no problems are raised in practical use. This is because since the average height (H) of the convexo-concave portion 18 of the tab wire 3 and the average particle diameter (D) ofNi particles of the conductive adhesive film 17 satisfy D ≧ H, the Ni particles are held by concave portions 18b of the convexo-concave portion 18 and made in contact with the Ag electrode 30. Therefore, the tab wire 3 of each of the examples makes it possible to increase the connection area between the convex portions 18a of the convexo-concave portion 18 and the Ag electrode 30 provided by Ni particles, and consequently to reduce resistance to conduction.

In particular, in the case when the average height (H) of the convexo-concave portion 18 of the tab wire 3 and the average particle diameter (D) of Ni particles of the conductive adhesive film 17 are the same (D = H) (example 1, example 4, example 6), the connection resistance is kept in a low level and good results are obtained.

Moreover, in accordance with the respective examples, the average particle diameter (D) of the conductive particles 23 (Ni particles) is desirably used in a range from 10 to 30µm. Furthermore, in accordance with the respective examples, the average height (H) of the convexo-concave portion 18 of the tab wire 3 is desirable used in a range from 10 to 20µm.

In comparative example 1, since no convexo-concave portion is formed on the tab wire, the connection resistance to the Ag electrode 30 is high in the initial value, and the value after the thermal impact test is also high, resulting in problems in practical use. In comparative example 2, since an insulating adhesive film is used for connection between the tab wire 3 and the Ag electrode 30, the connection resistance is unmeasureable in both of the initial value and the value after the thermal impact test, failing to be applied to practical use. In comparative example 3, since the average particle diameter (D) ofNi particles is smaller than the average height (H) of the convexo-concave portion of the tab wire, the Ni particles are not held by the concave portions of the tab wire and the Ag electrode, failing to devote to conductivity; therefore, the connection resistance abruptly rises, in particular, after the thermal impact test, resulting in problems in practical use.

### Reference Signs List

1...solar cell module, 2...solar cell, 3...tab wire, 4...strings, 5...matrix, 6...sheet, 7...surface cover, 8...back sheet, 9...metal frame, 10...photoelectric conversion element, 11...busbar electrode, 12...finger electrode, 13...rear surface electrode, 14...tab wire connection portion, 17...conductive adhesive film, 18... convexo-concave portion, 19...peeling process layer, 20...reel-wound body, 21...reel, 23...conductive particles, 24...peeling base member, 25...reel, 30...Ag electrode, 31...glass substrate

## Claims

1. A solar cell module comprising:
a plurality of solar cells and a tab wire that is connected to electrodes that are respectively formed on a surface of each of the solar cells and a rear surface of an adjacent solar cell, with a conductive adhesive agent containing spherical conductive particles being interpolated therebetween, so that the plural solar cells are mutually connected to one after another,
wherein the tab wire is provided with a convexo-concave portion formed on one surface thereof that is in contact with the conductive adhesive agent, with an average height (H) of the convexo-concave portion and an average particle diameter (D) of the conductive particles being allowed to satisfy D ≧ H.

2. The solar cell module according to claim 1, wherein before the tab wire is disposed on the surface electrode and the rear surface electrode, the conductive adhesive agent is preliminarily integrally formed on the surface thereof on which the convexo-concave portion is formed.

3. The solar cell module according to claim 2, wherein the tab wire is provided with a peeling process layer formed on the other surface on which no convexo-concave portion is formed.

4. The solar cell module according to any one of claims 1 to 3, wherein the average particle diameter (D) of the conductive particles is in a range from 10 to 30µm and the average height (H) of the convexo-concave portion is in a range from 10 to 20µm.

5. The solar cell module according to any one of claims 1 to 4, wherein the conductive particles are made ofNi.

6. A method for manufacturing a solar cell module comprising the steps of:
disposing one end of a tab wire on an electrode formed on a surface of each of solar cells with a conductive adhesive agent containing spherical conductive particles being interpolated therebetween, and the other end of the tab wire on a rear surface electrode of a solar cell adjacent to the solar cell with a conductive adhesive agent containing conductive particles being interpolated therebetween; and
thermally compressing the tab wire on the surface electrode and the rear surface electrode so that the tab wire is connected to the surface electrode and the rear surface electrode with the conductive adhesive agent,
where the tab wire is provided with a convexo-concave portion formed on one surface thereof that is in contact with the conductive adhesive agent, with an average height (H) of the convexo-concave portion and an average particle diameter (D) of the conductive particles being allowed to satisfy D ≧ H.

7. The method for manufacturing a solar cell module according to claim 6, wherein prior to the disposing step of the tab wire onto the surface electrode and the rear surface electrode, the conductive adhesive agent is preliminarily integrally formed on the surface thereof on which the convexo-concave portion is formed.

8. The method for manufacturing a solar cell module according to claim 6 or 7, wherein the tab wire is provided with a peeling process layer formed on the other surface on which no convexo-concave portion is formed, and prior to being disposed on the surface electrode and the rear surface electrode, the tab wire is wound around into a reel shape.

9. The method for manufacturing a solar cell module according to any one of claims 6 to 8, wherein the average particle diameter (D) of the conductive particles is in a range from 10 to 30µm and the average height (H) of the convexo-concave portion is in a range from 10 to 20µm.

10. The method for manufacturing a solar cell module according to any one of claims 6 to 9, wherein the conductive particles are made ofNi.

11. A reel-wound body comprising:
a tab wire that is connected to electrodes formed on a surface of each of solar cells and a rear surface of an adjacent solar cell respectively, with a conductive adhesive agent containing spherical conductive particles being interpolated therebetween, so that the plural solar cells are mutually connected to one after another, with the tab wire being wound around a reel,
wherein the tab wire is provided with a convexo-concave portion formed on one surface thereof that is in contact with the conductive adhesive agent, with an average height (H) of the convexo-concave portion and an average particle diameter (D) of the conductive particles being allowed to satisfy D ≧ H.

12. The reel-wound body according to claim 11, wherein the tab wire is designed such that the conductive adhesive agent is preliminarily integrally formed on the surface thereof on which the convexo-concave portion is formed.

13. The reel-wound body according to claim 11 or 12, wherein the tab wire is provided with a peeling process layer formed on the other surface on which no convexo-concave portion is formed.

14. The reel-wound body according to any one of claims 11 to 13, wherein the average particle diameter (D) of the conductive particles is in a range from 10 to 30µm and the average height (H) of the convexo-concave portion is in a range from 10 to 20µm.

15. The reel-wound body according to any one of claims 11 to 14, wherein the conductive particles are made ofNi.
